# EUROPEAN PATENT APPLICATION

(11) **EP 4 770 347 A1**
(43) Date of publication of application: **01.07.2026**
(21) Application number: 25779192.1
(22) Date of filing: 27.03.2025
(51) Int. Cl.: H10F 77/30

(54) **SOLAR CELL AND PREPARATION METHOD THEREFOR**

(30) Priority: 29.03.2024 CN 202410377188; 28.04.2024 CN 202410522507; 10.03.2025 CN 202510282775
(71) Applicant: CSI Cells (YangZhou) Co., Ltd., Yangzhou, Jiangsu 225101 (CN)
(72) Inventor: CHEN, Haiyan, Suzhou, Jiangsu 215129 (CN); DENG, Weiwei, Suzhou, Jiangsu 215129 (CN); XU, Tao, Suzhou, Jiangsu 215129 (CN)
(74) Representative: Rapisardi, Mariacristina
(86) International application number: PCT/CN2025/085293
(87) International publication number: WO 2025/201446

(57) **Abstract**

The present disclosure provides a solar cell and a preparation method therefor. The solar cell comprises a silicon substrate; the silicon substrate comprises a first surface and a second surface which are oppositely arranged; a diffusion layer is formed on the first surface of the silicon substrate; the first surface comprises first areas and second areas distributed at intervals; the second surface comprises third areas and fourth areas distributed at intervals; each first area is provided with a first tunnel passivation structure and a first electrode; and each third area is provided with a second tunnel passivation structure and a second electrode.

## Description

This application claims priority to Chinese Patent Application No. 202410377188.5 filed with the China National Intellectual Property Administration (CNIPA) on Mar. 29, 2024, Chinese Patent Application No. 202410522507.7 filed with the CNIPA on Apr. 28, 2024, and Chinese Patent Application No. 202510282775.0 filed with the CNIPA on Mar. 10, 2025, the disclosures of which are incorporated herein by reference in their entireties.

### TECHNICAL FIELD

The present application relates to the technical field of solar cells, for example, a solar cell and a preparation method therefor.

### BACKGROUND

With the rapid development of the photovoltaic industry, the performance and efficiency requirements for solar cells in both domestic and international photovoltaic markets continue to rise, and industry manufacturers are increasingly focusing on the research and development of high-efficiency cells. A tunnel oxide passivated contact (TOPCon) cell, with an ultra-thin tunnel oxide layer and a doped polysilicon layer sequentially prepared on the rear side of the cell, can enhance surface passivation of the cell, reduce the metal contact recombination current, and effectively improve the open-circuit voltage and the short-circuit current of the cell.

The TOPCon cell in the related art typically adopts a single-sided TOPCon structure, and a boron diffusion process is usually employed to prepare an emitting electrode on the front side. Due to a relatively low diffusion doping concentration, the contact resistance with the metal electrode is high. Meanwhile, since the metal is in direct contact with the silicon substrate, recombination in the metal region remains high, thereby leading to a large reverse saturation current and limiting further improvements in cell efficiency.

Therefore, in view of the above technical problems, it is necessary to provide a solar cell and a preparation method therefor.

### SUMMARY

The following is a summary of the subject matter described in detail in the present application. The summary is not intended to limit the scope of the claims.

The present application provides a solar cell and a preparation method therefor to improve cell efficiency and optimize the preparation process.

An embodiment of the present application provides the following technical solution.

A solar cell, which includes a silicon substrate. The silicon substrate includes a first surface and a second surface which are oppositely arranged. A diffusion layer is formed on the first surface of the silicon substrate. The first surface includes a first region and a second region distributed at intervals. The second surface includes a third region and a fourth region distributed at intervals. The first region is provided with a first tunnel passivation structure and a first electrode. The third region is provided with a second tunnel passivation structure and a second electrode.

In an embodiment, the first surface of the silicon substrate is recessed in the second region relative to the first region; and/or
the second surface of the silicon substrate is recessed in the fourth region relative to the third region.

In an embodiment, the recess depth of the first surface of the silicon substrate in the second region is 1 µm to 6 µm; and/or
the recess depth of the second surface of the silicon substrate in the fourth region is 1 µm to 6 µm.

In an embodiment, the height difference between a surface on a side of the first tunnel passivation structure facing away from the silicon substrate and the first surface of the silicon substrate in the second region is 0.1 µm to 6 µm; and/or
the height difference between a surface on a side of the second tunnel passivation structure facing away from the silicon substrate and the second surface of the silicon substrate in the fourth region is 0.1 µm to 6 µm.

In an embodiment, the diffusion layer includes a first diffusion layer located in the first region and a second diffusion layer located in the second region.

In an embodiment, the doping concentration of the second diffusion layer is greater than the doping concentration of the first diffusion layer; and/or
the doping concentration of the second diffusion layer is 1E18 cm⁻³ to 5E19 cm⁻³; and/or
the doping concentration of the first diffusion layer is 1E17 cm⁻³ to 5E19 cm⁻³.

In an embodiment, the first tunnel passivation structure includes a first tunnel layer and a first doped layer sequentially stacked in the first region, the second tunnel passivation structure includes a second tunnel layer and a second doped layer sequentially stacked in the third region, the first electrode is in electrical contact with the first doped layer, the second electrode is in electrical contact with the second doped layer, the first doped layer is of the same doping type as the diffusion layer, and the second doped layer is of an opposite doping type as the first doped layer.

In an embodiment, the diffusion layer includes a first diffusion layer located in the first region, and the doping concentration of the first diffusion layer is smaller than the doping concentration of the first doped layer.

In an embodiment, the first tunnel layer is any one or a combination of more of a silicon oxide layer or a silicon oxynitride layer; and/or
the thickness of the first tunnel layer is 1.5 nm to 2.5 nm or 1.8 nm to 2.2 nm; and/or
the first doped layer is a doped polysilicon layer with a thickness of 80 nm to 400 nm or 200 nm to 300 nm;
the doping concentration of the first doped layer is 1E19 cm⁻³ to 1E20 cm⁻³; and/or
the second tunnel layer is any one or a combination of more of a silicon oxide layer or a silicon oxynitride layer; and/or
the thickness of the second tunnel layer is 0.5 nm to 3 nm or 1.5 nm to 1.8 nm; and/or
the second doped layer is a doped polysilicon layer with a thickness of 50 nm to 150 nm or 90 nm to 130 nm; and/or
the silicon substrate is an N-type silicon substrate, the diffusion layer is a P-type diffusion layer, the first doped layer is a P-type doped layer, and the second doped layer is an N-type doped layer.

In an embodiment, the first surface of the silicon substrate is provided with a first passivation layer covering the first tunnel passivation structure and the second region of the silicon substrate, and the second surface of the silicon substrate is provided with a second passivation layer covering the second tunnel passivation structure and the fourth region of the silicon substrate.

In an embodiment, the height difference of a surface on a side of the first passivation layer facing away from the silicon substrate in the first region and the second region is 0.1 µm to 6 µm; and/or
the height difference of a surface on a side of the second passivation layer facing away from the silicon substrate in the third region and the fourth region is 0.1 µm to 6 µm.

In an embodiment, the first passivation layer is any one or a combination of more of a silicon oxide layer, an aluminum oxide layer, a silicon nitride layer or a silicon oxynitride layer; and/or
the second passivation layer is any one or a combination of more of a silicon oxide layer, an aluminum oxide layer, a silicon nitride layer or a silicon oxynitride layer.

In an embodiment, the first passivation layer includes an aluminum oxide layer and a silicon nitride layer sequentially stacked, where the thickness of the aluminum oxide layer is 3 nm to 6 nm, and the thickness of the silicon nitride layer is 60 nm to 100 nm; and/or
the second passivation layer includes an aluminum oxide layer and a silicon nitride layer sequentially stacked, where the thickness of the aluminum oxide layer is 3 nm to 6 nm, and the thickness of the silicon nitride layer is 60 nm to 100 nm.

In an embodiment, the first region on the first surface of the silicon substrate is a textured surface with a pyramid structure or a polished surface with a tower base, and the second region on the first surface of the silicon substrate is a textured surface with a pyramid structure.

In an embodiment, the pyramid structure in the first region has a base width of 0.5 µm to 1.5 µm and a height of 0.3 µm to 1 µm; or the tower base in the first region has a width of 1 µm to 5 µm and a height of the tower base of 0.1 µm to 0.4 µm; and/or
the pyramid structure in the second region has a base width of 1.5 µm to 2.2 µm and a height of 1 µm to 1.3 µm.

In an embodiment, the third region and the fourth region on the second surface of the silicon substrate are both polished surfaces.

In an embodiment, the width of the first region is 20 µm to 200 µm or 80 µm to 100 µm; and/or
the width of the third region is 20 µm to 200 µm or 80 µm to 100 µm.

Another embodiment of the present application provides the following technical solution.

A method for preparing a solar cell, which includes the following steps:
providing a silicon substrate, where the silicon substrate includes a first surface and a second surface which are oppositely arranged, the first surface includes a first region and a second region distributed at intervals, and the second surface includes a third region and a fourth region distributed at intervals;
preparing a first tunnel passivation structure in the first region on the first surface, and forming a diffusion layer below the first surface of the silicon substrate;
preparing a second tunnel passivation structure in the third region on the second surface; and
preparing a first electrode in the first region on the first surface, and preparing a second electrode in the third region on the second surface.

In an embodiment, the step where the first tunnel passivation structure is prepared in the first region on the first surface includes the following steps:
preparing a first tunnel layer, a first intrinsic layer and a first mask layer on the first surface;
subjecting the first mask layer in the second region to patterning and film opening by a laser process to expose the first intrinsic layer in the second region;
removing the first intrinsic layer and the first tunnel layer in the second region by a wet etching process to expose the silicon substrate in the second region;
removing the first mask layer in the first region to expose the first intrinsic layer in the first region; and
converting the first intrinsic layer into a first doped layer by a diffusion process.

In an embodiment, the preparation method further includes the following steps:
removing the first intrinsic layer and the first tunnel layer in the second region by a wet etching process, and etching a portion of the silicon substrate in the second region.

In an embodiment, the first intrinsic layer is an intrinsic polysilicon layer, the first tunnel layer is any one or a combination of more of a silicon oxide layer or a silicon oxynitride layer, and an etching solution adopted in the wet etching process is an alkaline solution; and/or
the first mask layer is any one or a combination of more of a silicon oxide layer, a silicon oxynitride layer or a silicon nitride layer, and the first mask layer is removed using an acid solution; and/or
the thickness of the first mask layer is 20 nm to 80 nm.

In an embodiment, the preparation method further includes the following steps:
before the preparation of the first tunnel layer, the first intrinsic layer and the first mask layer on the first surface, preparing a textured surface with a pyramid structure on the first surface of the silicon substrate by an alkaline texturing process, where the pyramid structure has a base width of 0.5 µm to 1.5 µm and a height of 0.3 µm to 1 µm; or preparing a polished surface with a tower base on the first surface of the silicon substrate by an alkaline texturing process and an alkaline polishing process, where the tower base has a width of 1 µm to 5 µm and a height of 0.1 µm to 0.4 µm; and
after the removal of the first intrinsic layer and the first tunnel layer in the second region by the wet etching process, preparing a textured surface with a pyramid structure in the second region on the first surface of the silicon substrate by an alkaline texturing process, where the pyramid structure has a base width of 1.5 µm to 2.2 µm and a height of 1 µm to 1.3 µm.

In an embodiment, the first intrinsic layer is converted into the first doped layer by a one-step diffusion process, and simultaneously, a first diffusion layer and a second diffusion layer are formed in the first region and the second region on the first surface of the silicon substrate, respectively.

In an embodiment, the doping concentration of the first diffusion layer is smaller than the doping concentration of the first doped layer, and the doping concentration of the second diffusion layer is greater than the doping concentration of the first diffusion layer.

In an embodiment, the preparation method further includes the following steps;
removing a parasitic diffusion layer generated on the second surface of the silicon substrate during the diffusion process using an acid solution; and
etching the second surface of the silicon substrate using an alkaline solution.

In an embodiment, the step where the second tunnel passivation structure is prepared in the third region on the second surface includes the following steps:
preparing a second tunnel layer, a second doped layer and a second mask layer on the second surface.
subjecting the second mask layer in the fourth region to patterning and film opening by a laser process to expose the second doped layer in the fourth region;
removing the second doped layer and the second tunnel layer in the fourth region by a wet etching process to expose the silicon substrate in the fourth region; and
removing the second mask layer in the third region to expose the second doped layer in the third region.

In an embodiment, the preparation method further includes the following steps:
removing the second doped layer and the second tunnel layer in the fourth region by a wet etching process, and etching a portion of the silicon substrate in the fourth region.

In an embodiment, the second doped layer is a doped polysilicon layer, the second tunnel layer is any one or a combination of more of a silicon oxide layer or a silicon oxynitride layer, and an etching solution adopted in the wet etching process is an alkaline solution; and/or
the second mask layer is any one or a combination of more of a silicon oxide layer, a silicon oxynitride layer or a silicon nitride layer, and the second mask layer is removed using an acid solution; and/or
the thickness of the second mask layer is 15 nm to 25 nm.

In an embodiment, the preparation method further includes the following step:
after the removal of the second doped layer and the second tunnel layer in the fourth region by the wet etching process, subjecting the silicon substrate in the fourth region to an alkaline polishing process.

In an embodiment, the preparation method further includes the following steps:
preparing a first passivation layer on the first surface of the silicon substrate, and preparing a first electrode penetrating the first passivation layer and in electrical contact with the first tunnel passivation structure in the first region on the first surface, where the first passivation layer is any one or a combination of more of a silicon oxide layer, an aluminum oxide layer, a silicon nitride layer or a silicon oxynitride layer; and/or
preparing a second passivation layer on the second surface of the silicon substrate, and preparing a second electrode penetrating the second passivation layer and in electrical contact with the second tunnel passivation structure in the third region on the second surface, where the second passivation layer is any one or a combination of more of a silicon oxide layer, an aluminum oxide layer, a silicon nitride layer or a silicon oxynitride layer.

Compared with the related art, the present application has the following beneficial effects.

The solar cell of the present application is a bifacial TOPCon cell, and both the front and rear sides are provided with local tunnel passivation structures. Therefore, the passivated contact in the front metal region is ensured, and parasitic absorption in the front non-metal region is reduced, thereby significantly improving cell efficiency.

Other aspects can be understood after the drawings and the detailed description are read and understood.

### BRIEF DESCRIPTION OF DRAWINGS

To more clearly illustrate technical solutions in embodiments of the present application or the related art, the following briefly describes the drawings required for describing the embodiments or the related art. Obviously, the drawings in the following description are only some embodiments described in the present application, and those of ordinary skill in the art may still derive other drawings from these drawings without creative work.
FIG. 1 is a structure view of a solar cell according to Example 1 of the present application.
FIG. 2 is a partial enlarged structure view of portion A in FIG. 1.
FIG. 3 is a partial enlarged structure view of portion B in FIG. 1.
FIG. 4a to 4k are flowcharts of the preparation process of the solar cell according to Example 1 of the present application.
FIG. 5 is a structure view of a solar cell according to Example 3 of the present application.
FIG. 6 is a structure view of a solar cell according to Example 4 of the present application.

### Description of main reference numbers:

10-substrate; 11-diffusion layer; 111-first diffusion layer; 112-second diffusion layer; 21-first tunnel layer; 22-second tunnel layer; 31-first doped layer; 31'-first intrinsic layer; 32-second doped layer; 41-first electrode; 42-second electrode; 51-first passivation layer; 52-second passivation layer; 511-first aluminum oxide layer; 512-first silicon nitride layer; 521-second aluminum oxide layer; 522-second silicon nitride layer; 61-first mask layer; 62 second mask layer; S1-first surface; S11-first region; S12-second region; S2-second surface; S21-third region; and S22-fourth region.

### DETAILED DESCRIPTION

To enable those skilled in the art to better understand the technical solutions in the present application, the technical solutions in the embodiments of the present application will be described clearly and comprehensively in combination with the drawings in the embodiments of the present application. Obviously, the embodiments described herein are merely part, not all, of the embodiments of the present application. Based on the embodiments in the present application, all other embodiments obtained by those of ordinary skill in the art without creative work are within the protection scope of the present application.

In the present application, unless otherwise expressly specified and limited, when a first feature is described as "on" or "below" a second feature, the first feature and the second feature may be in direct contact or may be in contact via an intermediate medium. Moreover, when the first feature is described as "on", "above", or "over" the second feature, the first feature is right on or obliquely on the second feature, or the first feature is simply at a higher level than the second feature. When the first feature is described as "under", "below", or "underneath" the second feature, the first feature is right below or obliquely below the second feature, or the first feature is simply at a lower level than the second feature.

The present application discloses a solar cell. The solar cell includes a silicon substrate. The silicon substrate includes a first surface and a second surface which are oppositely arranged. A diffusion layer is formed on the first surface of the silicon substrate. The first surface includes a first region and a second region distributed at intervals. The second surface includes a third region and a fourth region distributed at intervals. The first region is provided with a first tunnel passivation structure and a first electrode. The third region is provided with a second tunnel passivation structure and a second electrode.

The present application further discloses a method for preparing a solar cell. The preparation method includes the following steps.

A silicon substrate is provided, where the silicon substrate includes a first surface and a second surface which are oppositely arranged, the first surface includes a first region and a second region distributed at intervals, and the second surface includes a third region and a fourth region distributed at intervals.

A first tunnel passivation structure is prepared in the first region on the first surface, and a diffusion layer is formed below the first surface of the silicon substrate.

A second tunnel passivation structure is prepared in the third region on the second surface.

A first electrode is prepared in the first region on the first surface, and a second electrode is prepared in the third region on the second surface.

The solar cell of the present application is a bifacial TOPCon cell, and both the front and rear sides are provided with local tunnel passivation structures. Therefore, the passivated contact in the front metal region is ensured, and at the same time, the parasitic absorption in the front non-metal region is reduced, thereby significantly improving cell efficiency compared with the mono-facial TOPCon cell in the related art.

The present application will be further described below in combination with the specific embodiments.

### Example 1

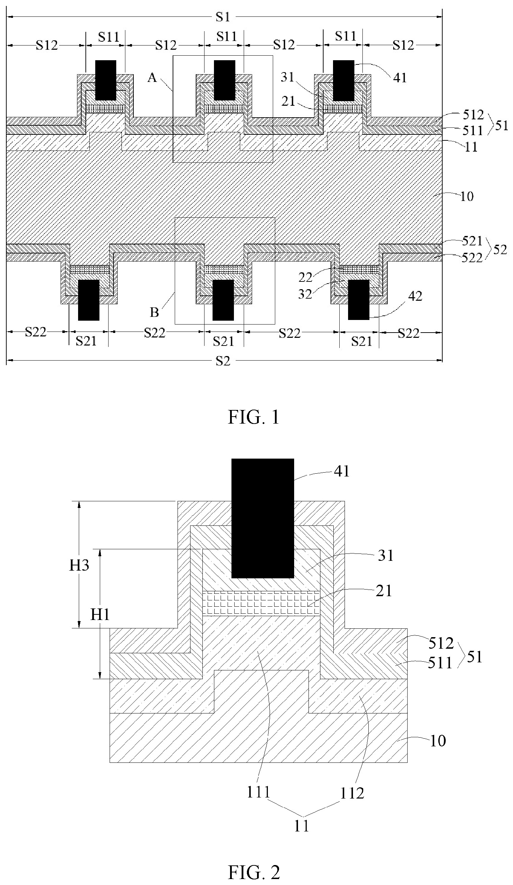

Referring to FIGs. 1, 2 and 3, the solar cell in this example was a bifacial TOPCon cell and included a silicon substrate 10. The silicon substrate 10 included a first surface S1 and a second surface S2 which were oppositely arranged. The first surface S1 included a first region S11 and a second region S12 distributed at intervals. The second surface S2 included a third region S21 and a fourth region S22 distributed at intervals. The first surface S1 was the front side (that is, a primary light-receiving surface) of the silicon substrate 10. The second surface S2 was the rear side (that is, a secondary light-receiving surface) of the silicon substrate 10. The first region S11 was a front metal region, the second region S12 was a front non-metal region, the third region S21 was a rear metal region, and the fourth region S22 was a rear non-metal region. Of course, in other examples, the first surface S1 may also be the rear side of the silicon substrate 10 (that is, the secondary light-receiving surface), and the second surface S2 was the front side (that is, the primary light-receiving surface) of the silicon substrate 10.

In the bifacial TOPCon cell of this example, the first surface S1 was provided with first tunnel passivation structures arranged at intervals, and the second surface S2 was provided with second tunnel passivation structures arranged at intervals. A diffusion layer 11 was formed across the entire first surface S1 through a diffusion process. Specifically, the first tunnel passivation structure included a first tunnel layer 21 and a first doped layer 31 sequentially stacked in the first region S11, and the second tunnel passivation structure included a second tunnel layer 22 and a second doped layer 32 sequentially stacked in the third region S21.

Additionally, the first region S11 on the first surface S1 was provided with a first electrode 41, and the first electrode 41 was in electrical contact with the first doped layer 31; the third region S21 of the second surface S2 was provided with a second electrode 42, and the second electrode 42 was in electrical contact with the second doped layer 32. In this example, the first doped layer 31 was of the same doping type as the diffusion layer 11, and the second doped layer 32 was of an opposite doping type as the first doped layer 31.

Further, in this example, the first surface S1 of the silicon substrate 10 was provided with a first passivation layer 51 covering the first tunnel passivation structure and the second region S12 of the silicon substrate 10, and the second surface S2 of the silicon substrate 10 was provided with a second passivation layer 52 covering the second tunnel passivation structure and the fourth region S22 of the silicon substrate 10.

The materials, thicknesses, doping types, and the like of layers in the solar cell of this example will be described in detail below.

In this example, the silicon substrate 10 was an N-type silicon substrate with an electrical resistivity of 0.3 Ω·cm to 7 Ω·cm, optionally, 0.5 Ω·cm to 3.5 Ω·cm. Optionally, in this example, a light-trapping structure was formed on the first surface S1 of the silicon substrate 10. For example, a textured surface with a pyramid structure may be prepared by an alkaline texturing process, or a polished surface with a tower base of a pyramid structure may be prepared by an alkaline texturing process and an alkaline polishing process. The entire second surface S2 of the silicon substrate 10 was a polished surface with a reflectivity of 45% to 55%.

In this example, the first tunnel layer 21 was any one or a combination of more of a silicon oxide layer or a silicon oxynitride layer, and has a thickness of 1.5 nm to 2.5 nm, optionally, 1.8 nm to 2.2 nm; the second tunnel layer 22 was any one or a combination of more of a silicon oxide layer or a silicon oxynitride layer, and has a thickness of 0.5 nm to 3 nm, optionally, 1.5 nm to 1.8 nm.

In this example, both the first doped layer 31 and the second doped layer 32 may be a single doped polysilicon layer or multiple doped polysilicon layers with a doping concentration gradient increasing from the inner side to the outer side (that is, in the direction away from the silicon substrate). The thickness of the first doped layer 31 was 80 nm to 400 nm, optionally, 200 nm to 300 nm, and the thickness of the second doped layer 32 was 50 nm to 150 nm, optionally, 90 nm to 130 nm. The first doped layer 31 was a P-type doped polysilicon layer, such as a boron-doped polysilicon layer; the second doped layer 32 was an N-type doped polysilicon layer, such as a phosphorus-doped polysilicon layer.

Additionally, in this example, the silicon substrate was an N-type silicon substrate, and the diffusion layer 11 was a P-type diffusion layer. For example, a boron diffusion layer was formed below the first surface S1 (that is, inside the silicon substrate) by a boron diffusion process, and a PN junction was then formed and generating electron-hole pairs upon illumination. The diffusion layer in the second region S12 can ensure a favorable photovoltaic effect, thereby increasing the current and improving cell efficiency. For example, the doping concentration of the diffusion layer 11 was 1E19 cm⁻³ to 1E20 cm⁻³.

Furthermore, in this example, the first doped layer 31 was a P-type doped polysilicon layer formed by a diffusion process. For example, an intrinsic polysilicon layer was first deposited on the first tunnel layer 21 and then converted into a boron-doped polysilicon layer by a boron diffusion process. Optionally, the first doped layer 31 and the diffusion layer 11 were prepared by a one-step diffusion process.

In combination with FIG. 2, in this example, the diffusion layer 11 included a first diffusion layer 111 located in the first region S11 and a second diffusion layer 112 located in the second region S12. For example, the doping concentration of the second diffusion layer 112 was 1E18 cm⁻³ to 5E19 cm⁻³, and the doping concentration of the first diffusion layer 111 was 1E17 cm⁻³ to 5E19 cm⁻³.

Referring to FIG. 1 and in combination with FIG. 2, in this example, on the first surface S1 of the silicon substrate 10, the first tunnel passivation structure was provided only in the first region S11, while the second region S12 was not provided with first tunnel passivation structure. Moreover, the second region S12 of the silicon substrate 10 was recessed relative to the first region S11. The height of a surface on a side of the first doped layer 31 facing away from the silicon substrate in the first region S11 was higher than the height of the first surface S1 of the silicon substrate 10 in the second region S12, and the height difference H1 was the sum of the thickness of the first tunnel layer 21, the thickness of the first doped layer 31, and the recess depth of the second region S12. In this example, the height difference H1 ranged from 0.1 µm to 6 µm. Optionally, the recess depth of the second region S12 relative to the first region S11 was 1 µm to 6 µm. The magnitude of the height difference H1 was influenced by the process and was typically at least 1 µm. The larger the height difference H1 was, the greater the light-receiving area on the front side was, and the better the light absorption was, thereby further improving cell efficiency.

Additionally, since the width of the second region S12 on the first surface S1 was larger while the width of the first region S11 was smaller, to ensure a good light-trapping effect on the first surface S1, a textured surface with a greater light-trapping effect needed to be formed in the second region S12 while the first region S11 may have a textured surface with a poorer light-trapping effect. The larger the size of the pyramid structure was, the better the light-trapping effect was.

For example, in this example, the first region S11 on the first surface S1 was a textured surface with a pyramid structure, and the pyramid structure had a base width of 1.5 µm to 2.2 µm and a height of 1 µm to 1.3 µm; the second region S12 on the first surface S1 was a textured surface with a pyramid structure, and the pyramid structure had a base width of 1.5 µm to 2.2 µm and a height of 1 µm to 1.3 µm. After the surface of the silicon substrate was subjected to an alkaline texturing process, a textured surface with a pyramid structure was formed. The base shape of the pyramid structure may be triangular, quadrilateral, and the like. The base width of the pyramid structure was defined as the average width of the base shape of the pyramid structure. Taking the base shape as a square as an example, the base width was the side length of the square.

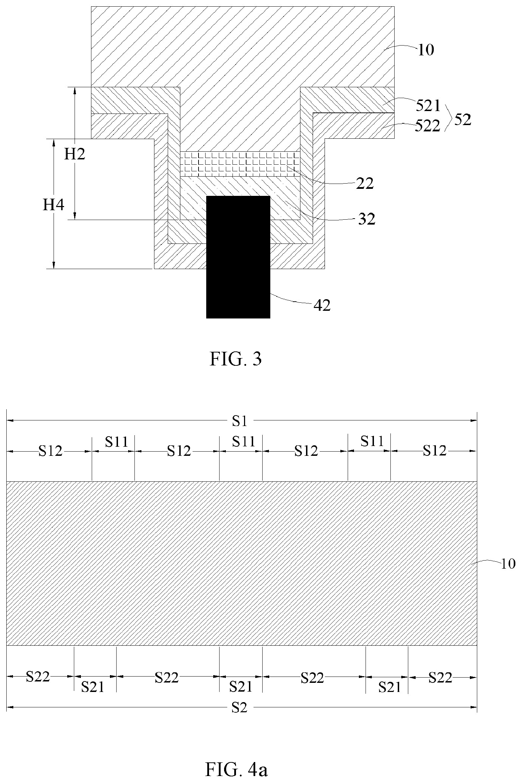

Referring to FIG. 1 and in combination with FIG. 3, in this example, on the second surface S2 of the silicon substrate 10, the second tunnel passivation structure was provided only in the third region S21, while the fourth region S22 was not provided with second tunnel passivation structure. Moreover, the fourth region S22 of the silicon substrate 10 was recessed relative to the third region S21. The height of a surface on a side of the second doped layer 32 facing away from the silicon substrate in the third region S21 was higher than the height of the second surface S2 of the silicon substrate 10 in the fourth region S22, and the height difference H2 was the sum of the thickness of the second tunnel layer 22, the thickness of the second doped layer 32, and the recess depth of the fourth region S22. In this example, the height difference H2 ranged from 0.1 µm to 6 µm. Optionally, the recess depth of the fourth region S22 relative to the third region S21 was 1 µm to 6 µm.

Additionally, in this example, a first passivation layer 51 and a second passivation layer 52 were stacked on the first surface S1 and the second surface S2 of the silicon substrate, respectively.

Specifically, the first passivation layer 51 covered the first tunnel passivation structure and the second region S12 of the silicon substrate 10, and the second passivation layer 52 covered the second tunnel passivation structure and the fourth region S22 of the silicon substrate 10. The first passivation layer 51 and the second passivation layer 52 may be any one or a combination of more of a silicon oxide (SiO_{X}) layer, an aluminum oxide (AlO_{X}) layer, a silicon nitride (SiN_{X}) layer or a silicon oxynitride (SiN_{X}O_{Y}) layer.

For example, in this example, the first passivation layer 51 included a first aluminum oxide layer 511 and a first silicon nitride layer 512 sequentially stacked, and the second passivation layer 52 included a second aluminum oxide layer 521 and a second silicon nitride layer 522 sequentially stacked. The first aluminum oxide layer 511 was directly in electrical contact with the surface of the silicon substrate in the second region S12, and the second aluminum oxide layer 521 was directly in electrical contact with the surface of the silicon substrate in the fourth region S22, thereby ensuring the passivation effect of the front and rear non-metal regions. Optionally, the thickness of both the first aluminum oxide layer 511 and the second aluminum oxide layer 521 was 3 nm to 6 nm, and the thickness of both the first silicon nitride layer 512 and the second silicon nitride layer 522 was 60 nm to 100 nm.

Referring to FIG. 2, in this example, since the thickness of the first passivation layer 51 in the first region S11 and the second region S12 was the same, a surface on a side of the first passivation layer 51 facing away from the silicon substrate 10 had a height difference H3 in the first region S11 and the second region S12, and the height difference H3 was equal to the height difference H1 and was 0.1 µm to 6 µm.

Referring to FIG. 3, in this example, since the thickness of the second passivation layer 52 in the third region S21 and the fourth region S22 was the same, a surface on a side of the second passivation layer 52 facing away from the silicon substrate 10 had a height difference H4 in the third region S21 and the fourth region S22, and the height difference H4 was equal to the height difference H2 and was 0.1 µm to 6 µm.

In this example, the first electrode 41 on the first surface S1 was in electrical contact with the first doped layer 31 but cannot damage the first tunnel layer 21 at the lowest layer, thereby ensuring the tunnel effect of the first tunnel layer 21. The second electrode 42 on the second surface S2 was in electrical contact with the second doped layer 32 but cannot damage the second tunnel layer 22 at the lowest layer, thereby ensuring the tunnel effect of the second tunnel layer 22.

Still referring to FIG. 2, in this example, the first electrode 41 was arranged directly above the first region S11, and the projection of the first electrode 41 on the first surface S1 was within the first region S11. Taking a grid line electrode as an example, the grid line electrode may include multiple primary grid lines and multiple secondary grid lines (or thin grid lines) vertically distributed. The primary grid line was typically prepared using a non-firing-through paste. In the present application, the first electrode 41 was described taking the secondary grid lines as an example. The width of the secondary grid line may be 5 µm to 40 µm. The first region S11 included multiple linear regions distributed at intervals. The width of the first region S11 was 20 µm to 200 µm, optionally, 80 µm to 100 µm.

Taking a 210 TOPCon cell as an example, the size of the cell was 203.396 ± 15 mm, the number of thin grid lines was 230, the width of the thin grid line was 15 µm to 100 µm, and the spacing between adjacent thin grid lines was 0.907 ± 0.015 mm. The spacing between adjacent first regions S11 was equal to the spacing between adjacent thin grid lines. Each first region S11 was distributed with one thin grid line, and the width of the first region S11 was greater than the width of the thin grid line. For example, the width of the thin grid line was 40 µm, and the width of the first region S11 was 80 µm.

The above description had been given by taking the first electrode 41 and the first region S11 on the first surface S1 of the silicon substrate 10 as an example. The second electrode 42 and the third region S21 on the second surface S2 of the silicon substrate 10 were substantially the same as the first electrode 41 and the first region S11 on the first surface S1, and the details were not repeated here.

The method for preparing the solar cell in this example specifically includes the following steps.

### 1. Double-sided polishing

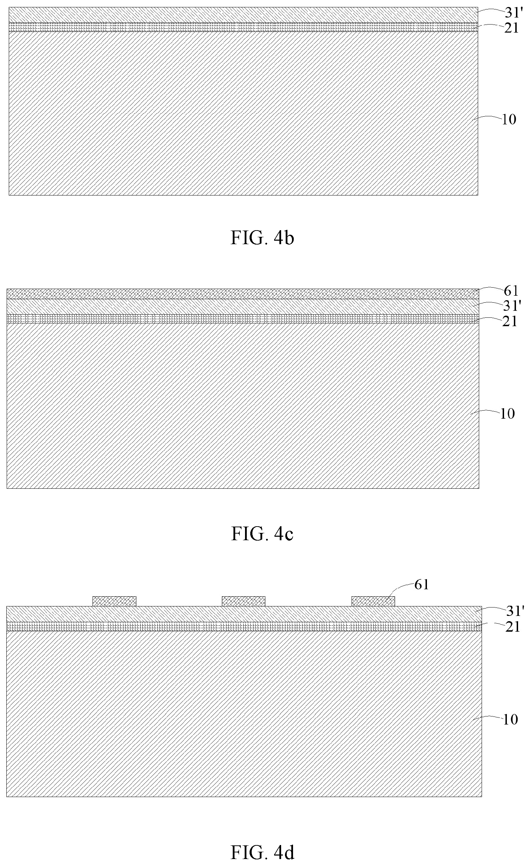

Referring to FIG. 4a, a silicon substrate 10 was provided. The silicon substrate 10 included a first surface S1 and a second surface S2 which were oppositely arranged. The first surface S1 included a first region S11 and a second region S12 distributed at intervals. The second surface S2 included a third region S21 and a fourth region S22 distributed at intervals. The first surface S1 was the front side (that is, a primary light-receiving surface) of the silicon substrate 10. The second surface S2 was the rear side (that is, a secondary light-receiving surface) of the silicon substrate 10. The first region S11 was a front metal region, the second region S12 was a front non-metal region, the third region S21 was a rear metal region, and the fourth region S22 was a rear non-metal region. Of course, in other examples, the first surface S1 may also be the rear side (that is, the secondary light-receiving surface) of the silicon substrate 10, and the second surface S2 was the front surface (that is, the primary light-receiving surface) of the silicon substrate 10.

In this example, the silicon substrate 10 was an N-type silicon substrate with an electrical resistivity of 0.3 Ω·cm to 7 Ω·cm, optionally, 0.5 Ω·cm to 3.5 Ω·cm. The first surface S1 and the second surface S2 of the silicon substrate 10 were polished by an alkaline polishing process to form polished surfaces with a reflectivity of 45% to 55%. The alkaline polishing solution adopted may contain NaOH, KOH, TMAH, and the like.

Optionally, the first surface S1 and the second surface S2 of the silicon substrate were subjected to an alkaline texturing process to prepare textured surfaces with a pyramid structure, where the pyramid structure had a base width of 0.5 µm to 1.5 µm and a height of 0.3 µm to 1 µm.

### 2. Preparation of the first tunnel passivation structure

A first tunnel layer 21 and a first doped layer 31 stacked sequentially were prepared in the first region S11 on the first surface S1, which specifically included the following steps.

First, referring to FIG. 4a, a first tunnel layer 21 and a first intrinsic layer 31' were deposited on the entire first surface S1.

For example, in this example, the deposition was performed by a low pressure chemical vapor deposition (LPCVD) process. The first tunnel layer 21 was any one or a combination of more of a silicon oxide layer or a silicon oxynitride layer and had a thickness of 1.5 nm to 2.5 nm, optionally, 1.8 nm to 2.2 nm. The first intrinsic layer 31' was an intrinsic polysilicon layer and had a thickness of 80 nm to 400 nm, optionally, 200 nm to 300 nm. Compared with the plasma enhanced chemical vapor deposition (PECVD) process, the intrinsic polysilicon layer film deposited by the LPCVD process had better quality.

Then, referring to FIG. 4c, a first mask layer 61 was deposited on the first intrinsic layer 31'.

For example, the first mask layer 61 was deposited by a PECVD process. The first mask layer 61 was an inorganic mask, such as a silicon oxide (SiO_{X}) mask, and had a thickness of 20 nm to 80 nm, optionally, 30 nm to 40 nm.

Referring to FIG. 4d, the first mask layer 61 in the second region S12 was subjected to patterning and film opening by a laser process to expose the first intrinsic layer 31' in the second region S12.

The laser process was used for patterning and film opening. According to the number of grid line electrodes and the width of the first region S11, the first mask layer 61 in the second region S12 was removed, and only the first mask layer 61 in the first region S11 was remained. For example, in this example, the width of the first region S11 was 20 µm to 200 µm, optionally, 80 µm to 100 µm.

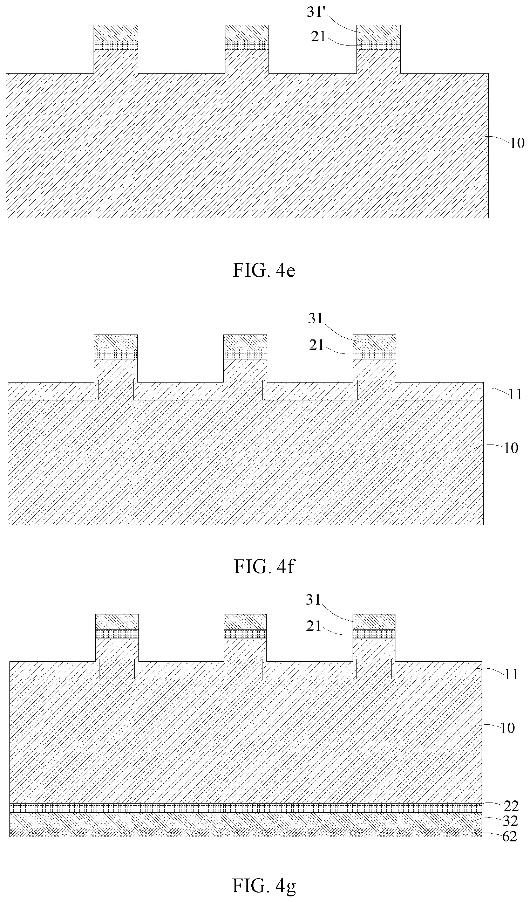

Finally, referring to FIG. 4e, the first intrinsic layer 31' and the first tunnel layer 21 in the second region S12 were removed by a wet etching process to expose the silicon substrate 10 in the second region S12, and the first mask layer 61 in the first region S11 was removed to expose the first intrinsic layer 31' in the first region S11.

The wet etching process included the following steps.

First, by an alkaline etching process, the first intrinsic layer 31' and the first tunnel layer 21 in the second region S12 were removed, and a portion of the silicon substrate in the second region S12 was etched to form a groove in the second region S12 on the first surface S1. Due to the blocking effect of the first mask layer 61 in the first region S11, the underlying first intrinsic layer 31' was not etched.

Then, the second region S12 on the first surface S1 was textured by an alkaline texturing process to prepare a textured surface with a pyramid structure in the second region S12. For example, in this example, the pyramid structure in the second region S12 had a base width of 1.5 µm to 2.2 µm and a height of 1 µm to 1.3 µm, while the first region S11 retained the original pyramid-structured textured surface with a base width of 0.5 µm to 1.5 µm and a height of 0.3 µm to 1 µm.

Finally, the first mask layer 61 was removed using an acid solution, and the silicon oxide formed on the surface during the deposition process was simultaneously removed.

### 3. Front-side diffusion process

Referring to FIG. 4f, the first surface S1 of the silicon substrate 10 and the first intrinsic layer 31' were diffused by a diffusion process to form a diffusion layer 11 and the first doped layer 31.

Specifically, a P-type doped diffusion layer 11 (that is, the P+ emitter) was formed on the first surface S1 of the silicon substrate 10 by a boron diffusion process at a diffusion temperature of 920 °C to 980 °C.

In the second region S12, since there was no blocking by the first tunnel layer 21 above, boron atoms diffused directly downward from the first surface S1 into the silicon substrate to form a second diffusion layer 112. In the first region S11, boron atoms first diffused into the intrinsic layer and then diffuse downward through the first tunnel layer 21 to form a first diffusion layer 111 in the first region S11. Additionally, the first intrinsic layer 31' may be simultaneously doped with boron during the diffusion process to form a boron-doped polysilicon layer. Optionally, the doping concentration of the second diffusion layer 112 was 1E18 cm⁻³ to 5E19 cm⁻³, the doping concentration of the first diffusion layer 111 was 1E17 cm⁻³ to 5E19 cm⁻³, and the doping concentration of the first doped layer 31 was 1E19 cm⁻³ to 1E20 cm⁻³. During the boron diffusion process, a borosilicate glass (BSG) layer was formed on the second surface S2 of the silicon substrate.

In this example, the intrinsic polysilicon layer was prepared first, and then the boron diffusion layer and the boron-doped polysilicon layer were simultaneously prepared by a one-step diffusion process, thereby optimizing the process and improving cell efficiency. If boron diffusion was first performed on the first surface S1 of the silicon substrate 10 and then the first tunnel layer and the boron-doped polysilicon layer were sequentially deposited, the boron diffusion layer formed in the second region S12 was etched away during the subsequent wet etching process on the second region S12, thereby reducing the built-in electric field of the front PN junction, affecting the photovoltaic effect, and reducing cell efficiency.

### 4. Rear-side parasitic diffusion removal and rear-side etching

A parasitic diffusion layer generated on the second surface S2 of the silicon substrate 10 during the diffusion process was removed using an acid solution through a chain machine. Taking the boron diffusion process as an example, the parasitic diffusion layer was borosilicate glass (BSG).

The second surface S2 of the silicon substrate 10 was etched using an alkaline solution through a trough machine to remove the P+ junction formed by parasitic diffusion on the rear side during the diffusion process.

### 5. Preparation of the second tunnel passivation structure

A second tunnel layer 22 and a second doped layer 32 stacked sequentially were prepared in the third region S21 on the second surface S1, which specifically includes the following steps.

First, referring to FIG. 4g, a second tunnel layer 22, a second doped layer 32, and a second mask layer 62 were deposited on the entire second surface S1.

For example, in this example, the deposition was performed by a PECVD process. The second tunnel layer 22 was any one or a combination of more of a silicon oxide layer or a silicon oxynitride layer and had a thickness of 0.5 nm to 3 nm, optionally, 1.5 nm to 1.8 nm. The second doped layer 32 was a doped polysilicon layer and had a thickness of 50 nm to 150 nm, optionally, 90 nm to 130 nm. The second mask layer 62 was an inorganic mask, such as a silicon oxide (SiO_{X}) mask, and had a thickness of 15 nm to 25 nm.

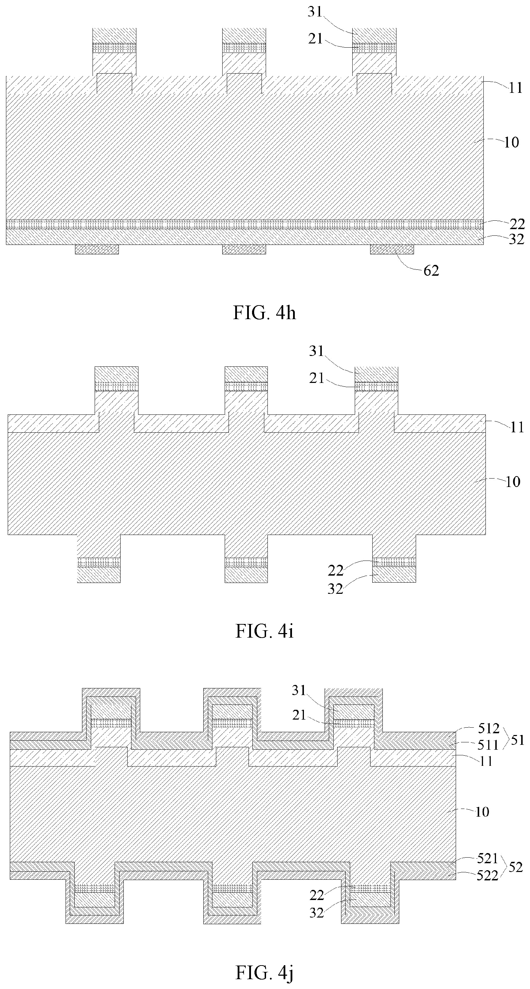

Referring to FIG. 4h, the second mask layer 62 in the fourth region S22 was subjected to patterning and film opening by a laser process to expose the second doped layer 32 in the fourth region S22.

The laser process was used for patterning and film opening. According to the number of grid line electrodes and the width of the third region S21, the second mask layer 62 in the fourth region S22 was removed, and only the second mask layer 62 in the third region S21 was remained. For example, in this example, the width of the third region S21 was 20 µm to 200 µm, optionally, 80 µm to 100 µm.

Finally, referring to FIG. 4i, the second doped layer 32 and the second tunnel layer 22 in the fourth region S22 are removed by a wet etching process to expose the silicon substrate 10 in the fourth region S22, and the second mask layer 62 in the third region S21 was removed to expose the second doped layer 32 in the first region S11.

The wet etching process includes the following steps.

First, by an alkaline etching process, the second doped layer 32 and the second tunnel layer 22 in the fourth region S22 were removed, and a portion of the silicon substrate in the fourth region S22 was etched to form a groove in the fourth region S22 on the second surface S2. Due to the blocking effect of the second mask layer 62 in the third region S21, the underlying second doped layer 32 was not etched. The alkaline etching process can simultaneously remove the polysilicon parasitically deposited on the front side.

Then, the fourth region S22 on the second surface S2 was polished by an alkaline polishing process.

Finally, the second mask layer 62 was removed using an acid solution, and the silicon oxide formed on the surface during the deposition process was simultaneously removed.

### 6. Double-sided passivation

Referring to FIG. 4j, passivation layers were prepared on the first surface S1 and the second surface S2.

Specifically, in this example, a first passivation layer 51 and a second passivation layer 52 were prepared by an atomic layer deposition (ALD) process on the first surface S1 and the second surface S2, respectively. The first passivation layer 51 included a first aluminum oxide layer 511 and a first silicon nitride layer 512 sequentially stacked, and the second passivation layer 52 included a second aluminum oxide layer 521 and a second silicon nitride layer 522 sequentially stacked. The thickness of both the first aluminum oxide layer 511 and the second aluminum oxide layer 521 was 3 nm to 6 nm, and the thickness of both the first silicon nitride layer 512 and the second silicon nitride layer 522 was 60 nm to 100 nm.

### 7. Preparation of metal electrodes

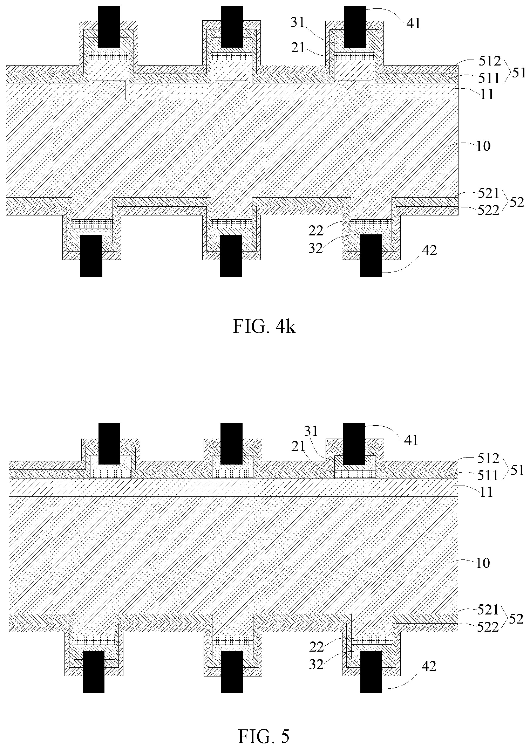

Referring to FIG. 4k, a first electrode 41 in ohmic contact with the silicon substrate 10 was prepared in the first region S11 on the first surface S1, and a second electrode 42 in ohmic contact with the silicon substrate 10 was prepared on the second surface S2.

Specifically, in this example, metal layers were printed by a screen printing process in the first region S11 on the first surface S1 and the third region S21 on the second surface S2, respectively, to form the first electrode 41 and the second electrode 42 which were are in ohmic contact with the silicon substrate 10. Optionally, in this example, both the first electrode 41 and the second electrode 42 were silver grid line electrodes.

### 8. LIF process

The electrodes were sintered by a laser induced firing (LIF) process, which can enhance the contact between the electrodes and the doped layers, thereby significantly reducing the contact resistance between the metal and the doped layers.

### Example 2

The structure and preparation method of the solar cell in this example are substantially the same as those in Example 1. The difference is that, in this example, the first region S11 on the first surface S1 was formed with a tower base with a poorer light-trapping effect, while the second region S12 was formed with a textured surface with a better light-trapping effect. Compared with a tower base of the same size, a pyramid structure had a better light-trapping effect.

For example, in this example, the first region S11 on the first surface S1 was a polished surface with a tower base, and the tower base had a width of 1 µm to 5 µm and a height of 0.1 µm to 0.4 µm; the second region S12 on the first surface S1 was a textured surface with a pyramid structure, and the pyramid structure had a base width of 1.5 µm to 2.2 µm and a height of 1 µm to 1.3 µm. After the surface of the silicon substrate was subjected to an alkaline texturing process, a textured surface with a pyramid structure was formed. After a subsequent alkaline polishing process, the pyramid structure was polished to form a tower base. That is, the tower base was the base left after the pyramid-structured textured surface was polished. The base shape of the pyramid structure and the base shape of the tower base may be triangular, quadrilateral, and the like. The base width of the pyramid structure was defined as the average width of the base shape of the pyramid structure, and the base width of the tower base was defined as the average width of the base shape of the tower base. Taking the base shape as a square as an example, the base width was the side length of the square.

### Example 3

Referring to FIG. 5, the structure and preparation method of the solar cell in this example are substantially the same as those in Example 1. The difference is that, in this example, the first surface S1 of the silicon substrate was flush in the first region S11 and the second region S12, and the parameters of the alkaline etching process were controlled during the wet etching process steps to stop etching immediately after the first intrinsic layer 31' and the first tunnel layer 21 in the second region S12 were removed.

Compared with Example 1, in this example, the surface of the second region is relatively smooth to enable the first passivation layer subsequently deposited on the silicon substrate to have better uniformity and better passivation performance, thereby ameliorating the recombination defect issue of the solar cell.

### Example 4

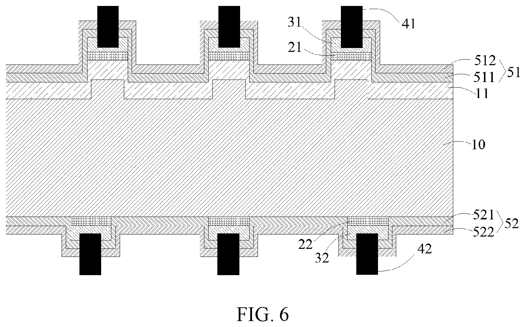

Referring to FIG. 6, the structure and preparation method of the solar cell in this example are substantially the same as those in Example 1. The difference is that, in this example, the second surface S2 of the silicon substrate was flush in the third region S21 and the fourth region S22, and the parameters of the alkaline etching process were controlled during the wet etching process steps to stop etching immediately after the second doped layer 32 and the second tunnel layer 22 in the fourth region S22 were removed.

Compared with Example 1, in this example, the surface of the fourth region was relatively smooth to enable the second passivation layer subsequently deposited on the silicon substrate to have better uniformity and better passivation performance, thereby ameliorating the recombination defect issue of the solar cell.

In the bifacial TOPCon cells of the above examples, both the front and rear sides adopt a poly-finger structure with local tunnel passivated contact to ensure contact passivation in the first region on the front side and the third region on the rear side, and at the same time, reduce parasitic absorption in the second region on the front side, thereby significantly improving cell efficiency compared with the mono-facial TOPCon cell in the related art. The preparation process is simple and suitable for mass production.

The metal regions on both the front and rear sides of the cell adopt a polysilicon process, thereby minimizing recombination in the metal regions, effectively reducing the reverse saturation current, and significantly improving cell efficiency.

It is apparent to those skilled in the art that the present application is not limited to the details of the above-described exemplary embodiments, and that the present application can be implemented in other specific forms without departing from the spirit or essential features of the present application. Accordingly, the embodiments are to be considered in all respects as illustrative and not restrictive. The scope of the present application is defined by the appended claims rather than by the foregoing description, and all changes that fall within the meaning and range of equivalency of the claims are therefore intended to be embraced therein. Any reference numerals in a claim should not be construed as limiting the claim concerned.

Furthermore, it is to be understood that although this specification is described in terms of embodiments, not every embodiment includes only one independent technical solution. Such a manner of description in the specification is merely for the sake of clarity, and those skilled in the art should take the specification as a whole. The technical solutions in the embodiments can also be appropriately combined to form other embodiments that can be understood by those skilled in the art.

## Claims

1. A solar cell, comprising a silicon substrate, wherein the silicon substrate comprises a first surface and a second surface which are opposite, a diffusion layer is formed at the first surface of the silicon substrate, the first surface comprises a first region and a second region distributed at intervals, the second surface comprises a third region and a fourth region distributed at intervals, the first region is provided with a first tunnel passivation structure and a first electrode, and the third region is provided with a second tunnel passivation structure and a second electrode.

2. The solar cell according to claim 1, wherein the first surface of the silicon substrate is recessed in the second region relative to the first region; and/or
the second surface of the silicon substrate is recessed in the fourth region relative to the third region.

3. The solar cell according to claim 1 or 2, wherein a recess depth of the first surface of the silicon substrate in the second region is 1 µm to 6 µm; and/or
a recess depth of the second surface of the silicon substrate in the fourth region is 1 µm to 6 µm.

4. The solar cell according to claim 1 or 2, wherein a height difference between a surface on a side of the first tunnel passivation structure facing away from the silicon substrate and the first surface of the silicon substrate in the second region is 0.1 µm to 6 µm; and/or
a height difference between a surface on a side of the second tunnel passivation structure facing away from the silicon substrate and the second surface of the silicon substrate in the fourth region is 0.1 µm to 6 µm.

5. The solar cell according to claim 1, wherein the diffusion layer comprises a first diffusion layer located in the first region and a second diffusion layer located in the second region.

6. The solar cell according to claim 5, wherein a doping concentration of the second diffusion layer is greater than a doping concentration of the first diffusion layer; and/or
the doping concentration of the second diffusion layer is 1E18 cm⁻³ to 5E19 cm⁻³; and/or
the doping concentration of the first diffusion layer is 1E17 cm⁻³ to 5E19 cm⁻³.

7. The solar cell according to claim 1, wherein the first tunnel passivation structure comprises a first tunnel layer and a first doped layer sequentially stacked in the first region, the second tunnel passivation structure comprises a second tunnel layer and a second doped layer sequentially stacked in the third region, the first electrode is in electrical contact with the first doped layer, the second electrode is in electrical contact with the second doped layer, the first doped layer is of a same doping type as the diffusion layer, and the second doped layer is of an opposite doping type as the first doped layer.

8. The solar cell according to claim 7, wherein the diffusion layer comprises a first diffusion layer located in the first region, and a doping concentration of the first diffusion layer is smaller than a doping concentration of the first doped layer.

9. The solar cell according to claim 7, wherein the first tunnel layer is any one or a combination of more of a silicon oxide layer or a silicon oxynitride layer; and/or
a thickness of the first tunnel layer is 1.5 nm to 2.5 nm or 1.8 nm to 2.2 nm; and/or
the first doped layer is a doped polysilicon layer with a thickness of 80 nm to 400 nm or 200 nm to 300 nm;
a doping concentration of the first doped layer is 1E19 cm⁻³ to 1E20 cm⁻³; and/or
the second tunnel layer is any one or a combination of more of a silicon oxide layer or a silicon oxynitride layer; and/or
a thickness of the second tunnel layer is 0.5 nm to 3 nm or 1.5 nm to 1.8 nm; and/or
the second doped layer is a doped polysilicon layer with a thickness of 50 nm to 150 nm or 90 nm to 130 nm; and/or
the silicon substrate is an N-type silicon substrate, the diffusion layer is a P-type diffusion layer, the first doped layer is a P-type doped layer, and the second doped layer is an N-type doped layer.

10. The solar cell according to claim 1, wherein the first surface of the silicon substrate is provided with a first passivation layer covering the first tunnel passivation structure and the second region of the silicon substrate, and the second surface of the silicon substrate is provided with a second passivation layer covering the second tunnel passivation structure and the fourth region of the silicon substrate.

11. The solar cell according to claim 10, wherein a height difference of a surface on a side of the first passivation layer facing away from the silicon substrate in the first region and the second region is 0.1 µm to 6 µm; and/or
a height difference of a surface on a side of the second passivation layer facing away from the silicon substrate in the third region and the fourth region is 0.1 µm to 6 µm.

12. The solar cell according to claim 10, wherein the first passivation layer is any one or a combination of more of a silicon oxide layer, an aluminum oxide layer, a silicon nitride layer or a silicon oxynitride layer; and/or
the second passivation layer is any one or a combination of more of a silicon oxide layer, an aluminum oxide layer, a silicon nitride layer or a silicon oxynitride layer.

13. The solar cell according to claim 10, wherein the first passivation layer comprises an aluminum oxide layer and a silicon nitride layer sequentially stacked, wherein a thickness of the aluminum oxide layer is 3 nm to 6 nm, and a thickness of the silicon nitride layer is 60 nm to 100 nm; and/or
the second passivation layer comprises an aluminum oxide layer and a silicon nitride layer sequentially stacked, wherein a thickness of the aluminum oxide layer is 3 nm to 6 nm, and a thickness of the silicon nitride layer is 60 nm to 100 nm.

14. The solar cell according to claim 1, wherein the first region on the first surface of the silicon substrate is a textured surface with a pyramid structure or a polished surface with a tower base, and the second region on the first surface of the silicon substrate is a textured surface with a pyramid structure.

15. The solar cell according to claim 14, wherein the pyramid structure in the first region has a base width of 0.5 µm to 1.5 µm and a height of 0.3 µm to 1 µm; or the tower base in the first region has a width of 1 µm to 5 µm and a height of the tower base of 0.1 µm to 0.4 µm; and/or
the pyramid structure in the second region has a base width of 1.5 µm to 2.2 µm and a height of 1 µm to 1.3 µm.

16. The solar cell according to claim 1, wherein the third region and the fourth region on the second surface of the silicon substrate are both polished surfaces.

17. The solar cell according to claim 1, wherein a width of the first region is 20 µm to 200 µm or 80 µm to 100 µm; and/or
a width of the third region is 20 µm to 200 µm or 80 µm to 100 µm.

18. A method for preparing a solar cell, comprising the following steps:
providing a silicon substrate, wherein the silicon substrate comprises a first surface and a second surface which are opposite, the first surface comprises a first region and a second region distributed at intervals, and the second surface comprises a third region and a fourth region distributed at intervals;
preparing a first tunnel passivation structure in the first region on the first surface, and forming a diffusion layer below the first surface of the silicon substrate;
preparing a second tunnel passivation structure in the third region on the second surface; and
preparing a first electrode in the first region on the first surface, and preparing a second electrode in the third region on the second surface.

19. The preparation method according to claim 18, wherein preparing the first tunnel passivation structure in the first region on the first surface comprises:
preparing a first tunnel layer, a first intrinsic layer and a first mask layer on the first surface;
subjecting the first mask layer in the second region to patterning and film opening by a laser process to expose the first intrinsic layer in the second region;
removing the first intrinsic layer and the first tunnel layer in the second region by a wet etching process to expose the silicon substrate in the second region;
removing the first mask layer in the first region to expose the first intrinsic layer in the first region; and
converting the first intrinsic layer into a first doped layer by a diffusion process.

20. The preparation method according to claim 19, further comprising:
removing the first intrinsic layer and the first tunnel layer in the second region by a wet etching process, and etching a portion of the silicon substrate in the second region.

21. The preparation method according to claim 19, wherein the first intrinsic layer is an intrinsic polysilicon layer, the first tunnel layer is any one or a combination of more of a silicon oxide layer or a silicon oxynitride layer, and an etching solution adopted in the wet etching process is an alkaline solution; and/or
the first mask layer is any one or a combination of more of a silicon oxide layer, a silicon oxynitride layer or a silicon nitride layer, and the first mask layer is removed using an acid solution; and/or
a thickness of the first mask layer is 20 nm to 80 nm.

22. The preparation method according to claim 19, further comprising:
before preparing the first tunnel layer, the first intrinsic layer and the first mask layer on the first surface, preparing a textured surface with a pyramid structure on the first surface of the silicon substrate by an alkaline texturing process, wherein the pyramid structure has a base width of 0.5 µm to 1.5 µm and a height of 0.3 µm to 1 µm; or preparing a polished surface with a tower base on the first surface of the silicon substrate by an alkaline texturing process and an alkaline polishing process, wherein the tower base has a width of 1 µm to 5 µm and a height of 0.1 µm to 0.4 µm; and
after removing the first intrinsic layer and the first tunnel layer in the second region by the wet etching process, preparing a textured surface with a pyramid structure in the second region on the first surface of the silicon substrate by an alkaline texturing process, wherein the pyramid structure has a base width of 1.5 µm to 2.2 µm and a height of 1 µm to 1.3 µm.

23. The preparation method according to claim 19, wherein the first intrinsic layer is converted into the first doped layer by a one-step diffusion process, and simultaneously, a first diffusion layer and a second diffusion layer are formed in the first region and the second region on the first surface of the silicon substrate, respectively.

24. The preparation method according to claim 23, wherein a doping concentration of the first diffusion layer is smaller than a doping concentration of the first doped layer, and a doping concentration of the second diffusion layer is greater than the doping concentration of the first diffusion layer.

25. The preparation method according to claim 19, further comprising:
removing a parasitic diffusion layer generated on the second surface of the silicon substrate during the diffusion process using an acid solution; and
etching the second surface of the silicon substrate using an alkaline solution.

26. The preparation method according to claim 18, wherein preparing the second tunnel passivation structure in the third region on the second surface comprises:
preparing a second tunnel layer, a second doped layer and a second mask layer on the second surface;
subjecting the second mask layer in the fourth region to patterning and film opening by a laser process to expose the second doped layer in the fourth region;
removing the second doped layer and the second tunnel layer in the fourth region by a wet etching process to expose the silicon substrate in the fourth region; and
removing the second mask layer in the third region to expose the second doped layer in the third region.

27. The preparation method according to claim 26, further comprising:
removing the second doped layer and the second tunnel layer in the fourth region by a wet etching process, and etching a portion of the silicon substrate in the fourth region.

28. The preparation method according to claim 26, wherein the second doped layer is a doped polysilicon layer, the second tunnel layer is any one or a combination of more of a silicon oxide layer or a silicon oxynitride layer, and an etching solution adopted in the wet etching process is an alkaline solution; and/or
the second mask layer is any one of a combination of more of a silicon oxide layer, a silicon oxynitride layer or a silicon nitride layer, and the second mask layer is removed using an acid solution; and/or
a thickness of the second mask layer is 15 nm to 25 nm.

29. The preparation method according to claim 26, further comprising:
after removing the second doped layer and the second tunnel layer in the fourth region by the wet etching process, subjecting the silicon substrate in the fourth region to an alkaline polishing process.

30. The preparation method according to claim 18, further comprising:
preparing a first passivation layer on the first surface of the silicon substrate, and preparing a first electrode penetrating the first passivation layer and in electrical contact with the first tunnel passivation structure in the first region on the first surface, wherein the first passivation layer is any one or a combination of more of a silicon oxide layer, an aluminum oxide layer, a silicon nitride layer or a silicon oxynitride layer; and/or
preparing a second passivation layer on the second surface of the silicon substrate, and preparing a second electrode penetrating the second passivation layer and in electrical contact with the second tunnel passivation structure in the third region on the second surface, wherein the second passivation layer is any one or a combination of more of a silicon oxide layer, an aluminum oxide layer, a silicon nitride layer or a silicon oxynitride layer.
